(19) Europäisches Patentamt / European Patent Office / Office européen des brevets

(11) **EP 4 568 008 A1**

(12) **EUROPEAN PATENT APPLICATION**

(43) Date of publication:
**11.06.2025 Bulletin 2025/24**

(21) Application number: 23215178.7

(22) Date of filing: **08.12.2023**

(51) International Patent Classification (IPC):
*H01P 1/04* (2006.01)    *H01P 5/10* (2006.01)
*H03H 7/42* (2006.01)

(52) Cooperative Patent Classification (CPC):
**H01P 5/10; H01P 1/047; H03H 7/42**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **NXP B.V.
5656 AG Eindhoven (NL)**

(72) Inventor: **BOSMA, Sjoerd
3012 GT Rotterdam (NL)**

(74) Representative: **Hardingham, Christopher Mark
NXP Semiconductors
Intellectual Property Group
The Cattle Barn
Upper Ashfield Farm, Hoe Lane
Romsey, Hampshire S051 9NJ (GB)**

(54) **PLANAR BALUN STRUCTURE**

(57)    The disclosure relates to a planar balun structure for routing millimetre-wave radar signals. Example embodiments include a planar balun structure (200) for routing millimetre-wave radar signals, the balun structure (200) comprising: a single-ended side (201); a differential side (203); a half-wavelength path (204) connecting the differential side (203) to the single-ended side (201), wherein the half-wavelength path (204) surrounds the single-ended side (201).

Fig. 2

**Description**

Field

The disclosure relates to a planar balun structure for routing millimetre-wave radar signals.

Background

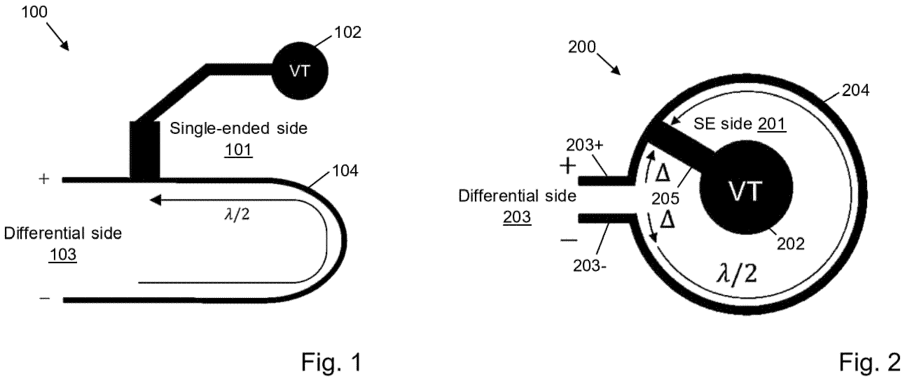

In-package balanced-to-unbalanced structures, known as baluns, typically in combination with vertical transitions between package layers and from package-to-PCB, are key components of high-performance millimetre-wave radar solutions. An example balun structure 100 for such a millimetre wave application is illustrated schematically in Figure 1. The balun structure 100 has a single-ended side 101 connected to a vertical transition (VT) conductor 102 and a differential side 103 having a hairpin-shaped half-wavelength conductor path 104. The λ/2 path length ensures a high common-mode rejection. The VT conductor 102 is connected by the single-ended side 101 to the differential side 103. The VT 102 may provide a single-ended coaxial-type transition from one package layer to another package layer using a stack of pads connected with vias with an outer conductor formed by a ring of vias. The VT 102 may alternatively provide a transition from a package to a PCB in which central and outer conductors are formed by solder balls. A combination of the two alternatives may also be implemented.

When designing balun structures implementing routing for a die-to-package transition and package-to-PCB transition, there are strict restrictions on how much space the mm-wave part can occupy on the package. If it is possible to reduce the size of such mm-wave structures, this can save a non-trivial amount of package size that can be allocated to digital and power routing or could allow for smaller overall package dimensions.

Summary

According to a first aspect there is provided a planar balun structure for routing millimetre-wave radar signals, the balun structure comprising:

> a single-ended side;
> a differential side;
> a half-wavelength path connecting the differential side to the single-ended side,
> wherein the half-wavelength path surrounds the single-ended side.

In some examples, the half-wavelength path forms a circular conductor path around the single-ended side.

In some examples, the single-ended side comprises a central conductor and a radial conductor path extending radially between the central conductor and the half-wavelength path.

In some examples, the differential side comprises a pair of linear parallel conductors, the radial conductor path being oriented at an angle to the pair of linear parallel conductors.

The half-wavelength path may be between around 0.6 mm and 2 mm long.

According to a second aspect there is provided a multilayer packaged integrated circuit device comprising:

> a first layer comprising a balun structure according to the first aspect; and
> a second layer comprising a conductor connected to the single-ended side of the balun structure by a conductive via connecting the first and second layers.

According to a third aspect there is provided a millimetre-wave radar assembly comprising:

> the multilayer packaged integrated circuit device of the second aspect; and
> a PCB conductively connected to the conductor of the second layer by a solder ball.

According to a fourth aspect there is provided a method of designing a planar balun structure for routing millimetre-wave radar signals, the balun structure comprising:

> a single-ended side;
> a differential side;
> a half-wavelength path connecting the differential side to the single-ended side, wherein the half-wavelength path forms a conductor path around the single-ended side, the single-ended side comprising a central conductor and a radial conductor path extending between the central conductor and the half-wavelength path,
> the method comprising adjusting an angle between the radial conductor path and the pair of linear parallel conductors to tune a common-mode rejection resonance frequency of the balun structure.

The angle may be adjusted independently of other dimensions of the balun structure.

The half-wavelength path may form a circular conductor path around the single-ended side.

The half-wavelength path may be between around 0.6 mm and 2 mm long.

The planar balun structure may be part of a multilayer packaged integrated circuit device comprising:

> a first layer comprising the balun structure;
> a second layer comprising a conductor connected to the single-ended side of the balun structure by a conductive via connecting the first and second layers.

The multilayer packaged integrated circuit device may be part of a millimetre-wave radar assembly further comprising a PCB conductively connected to the conductor of the second layer by a solder ball.

These and other aspects of the invention will be apparent from, and elucidated with reference to, the embodiments described hereinafter.

Brief description of Drawings

Embodiments will be described, by way of example only, with reference to the drawings, in which:

Figure 1 is a schematic diagram of an example planar balun structure;

Figure 2 is a schematic diagram of an example planar balun structure according to the present disclosure;

Figure 3 is a schematic diagram of an example current implementation of a planar balun structure for mm-wave routing;

Figure 4 is a schematic diagram of an example implementation of a planar balun structure for mm-wave routing according to the present disclosure;

Figure 5a is a schematic plan view of an example planar balun structure according to the present disclosure;

Figure 5b is a schematic sectional side view of the balun structure of Figure 5a as part of a package and PCB assembly;

Figure 6 is a schematic plan view of an example implementation of a balun structure according to the present disclosure for measurement with RF probes;

Figure 7 is a plot of simulated mm-wave performance of the example balun structure of Figure 6 covering a radar band between 76 and 81 GHz; and

Figure 8 is a schematic plan view of an example planar balun structure illustrating an intercept angle of a radial conductor.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

Detailed description of embodiments

Figure 2 illustrates schematically a plan view of an example planar balun structure 200 for routing mm-wave radar signals. As with the example illustrated in Figure 1, the balun structure 200 comprises a single-ended side 201 and a differential side 203, with a half-wavelength path 204 connecting the differential side 203 to the single-ended side 201. Instead of the hairpin-shaped half-wavelength structure of Figure 1 with the single-ended side extending away from the half-wavelength structure, in the example of Figure 2 the half-wavelength path 204 surrounds the single-ended side 201. This arrangement can result in a smaller overall size of balun structure 200, thereby saving space on a package on which the balun structure 200 is provided.

The half-wavelength path 204 in the example in Figure 2 forms a circular conductor path around the single-ended side 201. In other examples the half-wavelength path may follow a non-circular shaped path, for example an elliptical, polygonal or irregularly shaped path. The single-ended side 201 comprises a central conductor 202, which may be termed a vertical transition (VT) when the single-ended side 201 connects to another layer of a multilayer package with a via extending through the package.

A radial conductor path 205 extends between the central conductor 202 and the half-wavelength path 204. As detailed below, an angle of the radial conductor relative to the differential side conductors determines the length of the half-wavelength path 204, which allows the common-mode rejection resonance (CMRR) frequency to be adjusted independently of other design parameters of the balun structure 200.

The differential side 203 comprises a pair of linear parallel conductors 203+, 203-. The shortest conductor length between differential line and single-ended line is $\Delta$ for conductor 203+; the longest length is $\Delta + \lambda/2$ indicated in Figure 2. The length $\Delta$ may be arbitrary within the manufacturing capabilities of the package manufacturing process. For example, at least 20 micrometers in some example implementations.

For mm-wave applications in vehicle radar systems operating between around 76 and 81 GHz, the half-wavelength path 204 may be up to around 2 mm. Taking into account the dielectric material of the package, the wavelength is reduced by a factor of $\sqrt{\varepsilon_r}$, where $\varepsilon_r$ is typically between around 2 and 10 depending on the package material. A diameter of the circular conductor path forming the half-wavelength path 204 may therefore typically be less than around 0.6 mm. The diameter of the circular conductor path is larger than a spacing between the parallel conductors 203+, 203- of the differential side 203, and may for example be more than three times larger.

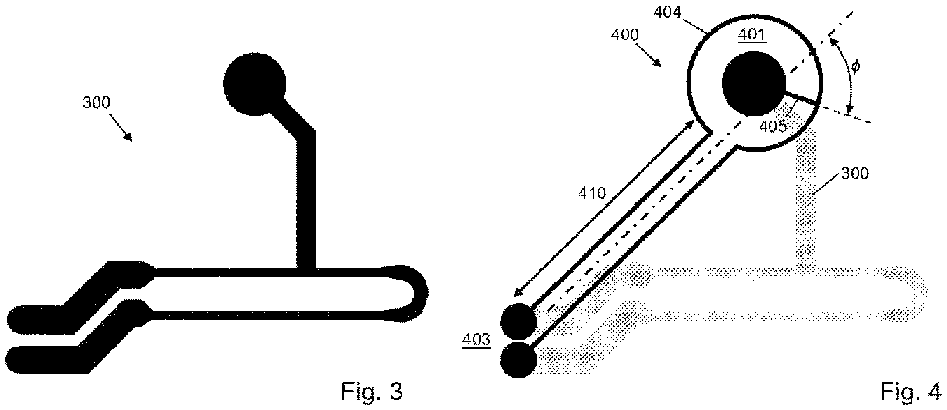

Because differential routing to the single-ended side can be done in a straight line, the overall size of the balun structure 200 can be reduced compared to a typical current implementation. Figure 3 illustrates an example balun structure 300 as currently implemented in a radar transceiver package, in which the half-wavelength path is provided by a hairpin-shaped conductor. Figure 4 illustrates the balun structure 300 overlaid with an example balun structure 400 according to the present disclosure. The area required for the balun structure 400 is substantially reduced. The differential conductor 410 between the circular conductor path 404 and the differential side 403 allows for impedance transformation between the differential side 403 and the single-ended side 401. The CMRR frequency can be tuned by adjusting the angle $\phi$ between the radial conductor path 405 and the pair of conductors connecting the differential side 403 to the circular conductor path 404.

The shorter routing between the differential side 403 and single-ended side 401 in the example illustrated in Figure 4 can allow for a lower insertion loss, a lower radiation loss, more flexible routing and a more compact package.

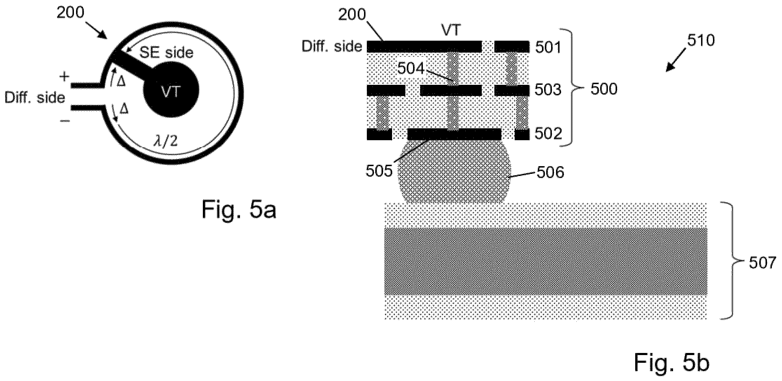

Figure 5a illustrates a further plan view of the balun structure 200 alongside, in Figure 5b, a schematic sectional view of the balun structure 200 in a first layer 501 of a multi-layer package 500 as part of a mm-wave radar assembly 510. A second layer 502 of the package 500 comprises a conductor 505 connected to the single-ended side of the balun structure 200 by a conductive via 504, which connects the first and second layers 501, 502 through a thickness of the package 500. One or more further intermediate layers 503 may also be provided between the first and second layers 501, 502 of the package 500.

The package 500 can be mounted to a PCB 507 to form a millimetre-wave radar assembly 510 comprising the multilayer package 500 and the PCB 507, the PCB being conductively connected to the second layer 502 of the package by a solder ball connection 506. Figure 5b only shows a relevant portion of the overall assembly, which will typically incorporate a plurality of solder balls connecting the package 500 to the PCB, together with other components in the PCB and package 500.

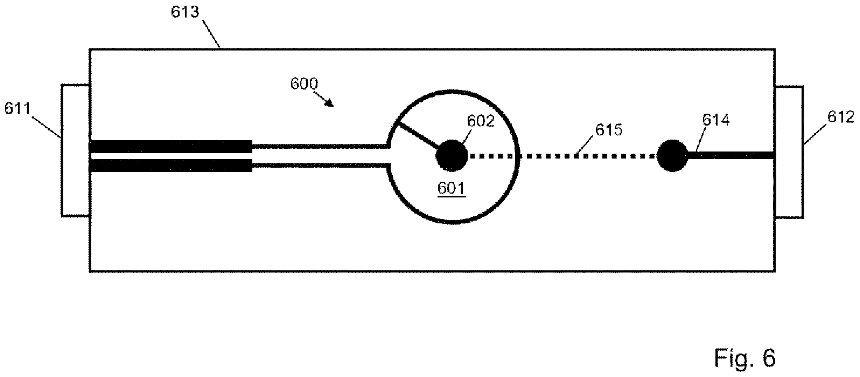

Figure 6 illustrates an example balun structure 600 connected between a differential port 611 and a single-ended port 612 on a package 613 designed to enable the properties of the balun structure 600 to be measured with RF probes. The differential port 611 may have a 100Ω port impedance representing a differential probe. The single-ended port 612 may have a 50Ω impedance representing a single-ended probe. The single-ended port 612 is connected to a short single-ended line 614 that is connected to the vertical transition connector 602 of the single-ended side 601 of the balun 600 by a connection line 615 passing along a second layer of the package 613. The connection line 615 is connected to the single-ended line 614 and to the VT connector 602 with vias passing through a thickness of the package 613.

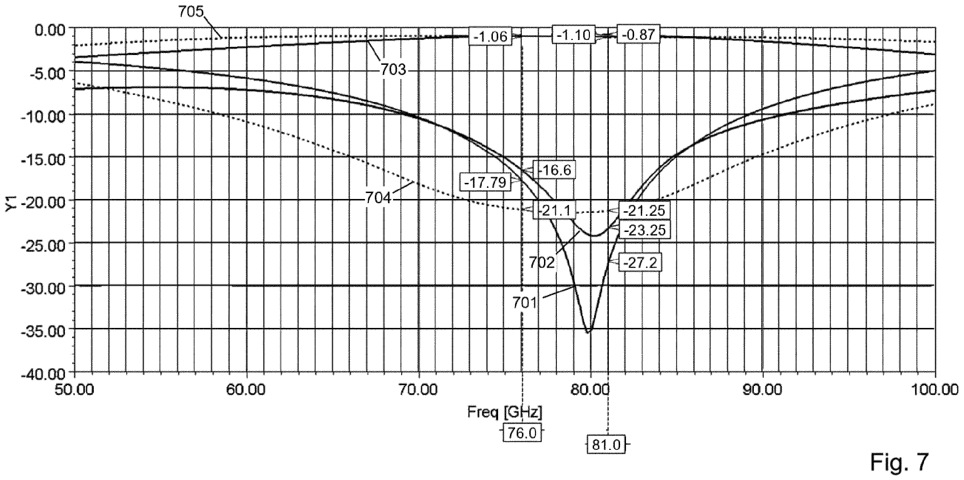

Figure 7 illustrates simulated results of a mm-wave implementation of the type illustrated in Figure 6, in which the balun 600 is designed for operation within the 76-81 GHz automotive radar band. The results show a >15 dB return loss from the differential side 701 and the single-ended side 702, a <1 dB insertion loss 703, a >20 dB common mode rejection 704 and a <1 dB common-mode return loss 705.

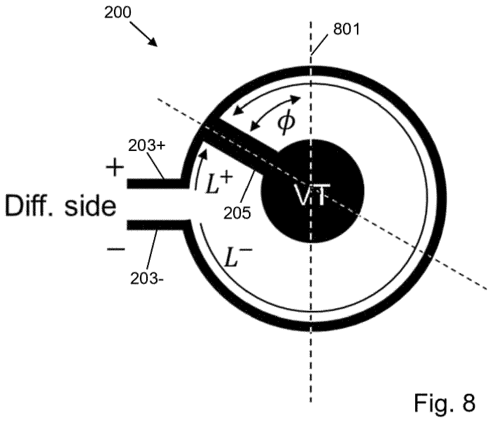

Simple control over the resonant frequency of the common-mode rejection can be achieved by changing the intercept angle between the balun and the pad, which is indicated as the angle $\phi$ in Figure 8. In this case, the angle $\phi$ is measured between the radial conductor 205 and a line 801 orthogonal to the differential side conductors 203+, 203-. The angle $\phi$ may alternatively be measured between the radial conductor path 205 and the conductors 203+, 203-as illustrated in Figure 4. The net effect of changing the angle $\phi$ is to change the relative path length between the negative terminal ($L^-$) and positive terminal ($L^+$). This change does not meaningfully impact the input impedance (from either side) of the overall balun-VT. Thus, the angle $\phi$ is effectively a free or independent parameter that can be used to tune the common-mode rejection resonance frequency of the balun 200 following other optimizations.

From reading the present disclosure, other variations and modifications will be apparent to the skilled person. Such variations and modifications may involve equivalent and other features which are already known in the art of mm-wave structures, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A planar balun structure (200) for routing millimetre-wave radar signals, the balun structure (200) comprising:

   a single-ended side (201);
   a differential side (203);
   a half-wavelength path (204) connecting the differential side (203) to the single-ended side (201),
   wherein the half-wavelength path (204) surrounds the single-ended side (201).

2. The balun structure (200) of claim 1, wherein the half-wavelength path (204) forms a circular conductor path around the single-ended side (201).

3. The balun structure (200) of claim 1 or claim 2, wherein the single-ended side (201) comprises a central conductor (202) and a radial conductor path (205) extending radially between the central conductor (202) and the half-wavelength path (204).

4. The balun structure (200) of claim 3, wherein the differential side (203) comprises a pair of linear parallel conductors (203+, 203-), the radial conductor path (205) being oriented at an angle ($\phi$) to the pair of linear parallel conductors (203+, 203-).

5. The balun structure (200) of any preceding claim, wherein the half-wavelength path (204) is between around 0.6 mm and 2 mm long.

6. A multilayer packaged integrated circuit device (500) comprising:

   a first layer (501) comprising a balun structure (200) according to any preceding claim; and
   a second layer (502) comprising a conductor (505) connected to the single-ended side of the balun structure (200) by a conductive via (504) connecting the first and second layers (501, 502).

7. A millimetre-wave radar assembly (510) comprising:

   the multilayer packaged integrated circuit device (500) of claim 6; and
   a PCB (507) conductively connected to the conductor (505) of the second layer (502) by a solder ball (506).

8. A method of designing a planar balun structure (200) for routing millimetre-wave radar signals, the balun structure (200) comprising:

   a single-ended side (201);

   a differential side (203);
   a half-wavelength path (204) connecting the differential side (203) to the single-ended side (201), wherein the half-wavelength path (204) forms a conductor path around the single-ended side (201), the single-ended side (201) comprising a central conductor (202) and a radial conductor path (205) extending between the central conductor (202) and the half-wavelength path (204),
   the method comprising adjusting an angle ($\phi$) between the radial conductor path (205) and the pair of linear parallel conductors (203+, 203-) to tune a common-mode rejection resonance frequency of the balun structure (200).

9. The method of claim 8, wherein the angle ($\phi$) is adjusted independently of other dimensions of the balun structure (200).

10. The method of claim 8 or claim 9, wherein the half-wavelength path (204) forms a circular conductor path around the single-ended side (201).

11. The method of any one of claims 8 to 10, wherein the half-wavelength path (204) is between around 0.6 mm and 2 mm long.

12. The method of any one of claims 8 to 11, wherein the planar balun structure (200) is part of a multilayer packaged integrated circuit device (500) comprising:

   a first layer (501) comprising the balun structure (200);
   a second layer (502) comprising a conductor (505) connected to the single-ended side of the balun structure (200) by a conductive via (504) connecting the first and second layers (501, 502).

13. The method of claim 12, wherein the multilayer packaged integrated circuit device (500) is part of a millimetre-wave radar assembly (510) further comprising a PCB (507) conductively connected to the conductor (505) of the second layer (502) by a solder ball (506).

**Amended claims in accordance with Rule 137(2) EPC.**

1. A planar balun structure (200) for routing millimetre-wave radar signals, the balun structure (200) comprising:

   a single-ended side (201);
   a differential side (203);
   a circular conductor path comprising a half-wavelength, $\lambda/2$, path (204) connecting the differential side (203) to the single-ended side (201), wherein the half-wavelength path (204) surrounds the single-ended side (201), the single-ended side (201) comprising a central conductor (202) and a radial conductor path (205) extending radially between the central conductor (202) and the half-wavelength path (204), wherein the differential side (203) comprises a pair of linear parallel conductors (203+, 203-), the radial conductor path (205) being oriented at an angle ($\phi$) to the pair of linear parallel conductors (203+, 203-), the circular conductor path having a first shorter conductor length $\Delta$ between a first one (203+) of the pair of linear parallel conductors (203+) and the radial conductor path (205) and a second longer conductor length $\Delta+\lambda/2$ between a second one (203-) of the pair of linear parallel conductors and the radial conductor path (205).

2. The balun structure (200) of claim 1, wherein the half-wavelength path (204) is between around 0.6 mm and 2 mm long.

3. A multilayer packaged integrated circuit device (500) comprising:

   a first layer (501) comprising a balun structure (200) according to any preceding claim; and
   a second layer (502) comprising a conductor (505) connected to the single-ended side of the balun structure (200) by a conductive via (504) connecting the first and second layers (501, 502).

4. A millimetre-wave radar assembly (510) comprising:

   the multilayer packaged integrated circuit device (500) of claim 3; and
   a PCB (507) conductively connected to the conductor (505) of the second layer (502) by a solder ball (506).

5. A method of designing a planar balun structure (200) for routing millimetre-wave radar signals, the balun structure (200) comprising:

   a single-ended side (201);
   a differential side (203) comprising a pair of linear parallel conductors (203+, 203-);
   a circular conductor path comprising a half-wavelength path (204) connecting the differential side (203) to the single-ended side (201), wherein the half-wavelength path (204) forms a conductor path around the single-ended side (201), the single-ended side (201) comprising a central conductor (202) and a radial conductor path (205) extending between the central conductor

(202) and the half-wavelength path (204), the circular conductor path having a first shorter conductor length $\Delta$ between a first one (203+) of the pair of linear parallel conductors (203+) and the radial conductor path (205) and a second longer conductor length $\Delta+\lambda/2$ between a second one (203-) of the pair of linear parallel conductors and the radial conductor path (205) the method comprising adjusting an angle ($\phi$) between the radial conductor path (205) and the pair of linear parallel conductors (203+, 203-) to tune a common-mode rejection resonance frequency of the balun structure (200).

6. The method of claim 5, wherein the angle ($\phi$) is adjusted independently of other dimensions of the balun structure (200).

7. The method of claim 5 or claim 6, wherein the half-wavelength path (204) is between around 0.6 mm and 2 mm long.

8. The method of any one of claims 5 to 7, wherein the planar balun structure (200) is part of a multilayer packaged integrated circuit device (500) comprising:

   a first layer (501) comprising the balun structure (200);
   a second layer (502) comprising a conductor (505) connected to the single-ended side of the balun structure (200) by a conductive via (504) connecting the first and second layers (501, 502).

9. The method of claim 8, wherein the multilayer packaged integrated circuit device (500) is part of a millimetre-wave radar assembly (510) further comprising a PCB (507) conductively connected to the conductor (505) of the second layer (502) by a solder ball (506).

Fig. 1

Fig. 2

Fig. 4

Fig. 3

Fig. 5a

Fig. 5b

EP 4 568 008 A1

Fig. 6

Fig. 7

Fig. 8

# EP 4 568 008 A1

**Europäisches Patentamt**
**European Patent Office**
**Office européen des brevets**

## EUROPEAN SEARCH REPORT

**Application Number**

EP 23 21 5178

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JUNG KOOHO ET AL: "Rat-Race Hybrid Ring Realized In Two-Layer Printed Process", IEEE MICROWAVE AND WIRELESS COMPONENTS LETTERS, IEEE SERVICE CENTER, NEW YORK, NY, US, vol. 26, no. 10, 1 October 2016 (2016-10-01), pages 768-770, XP011624850, ISSN: 1531-1309, DOI: 10.1109/LMWC.2016.2605463 [retrieved on 2016-10-05] | 1-5 | INV. H01P1/04 H01P5/10 H03H7/42 |
| Y | * sec I; | 6,7 | |
| A | page 768 * * figure 1 * | 8-13 | |
| Y | US 2023/198114 A1 (TIEMEIJER LUKAS FREDERIK [NL] ET AL) 22 June 2023 (2023-06-22) * paragraph [0030] * * paragraph [0036] * * figures 1-3 * | 6,7 | |
| | | | TECHNICAL FIELDS SEARCHED (IPC) |
| A | US 4 008 438 A (SHINKAWA KEIRO ET AL) 15 February 1977 (1977-02-15) * column 3, line 42 - column 4, line 55 * * figures 3-4 * | 1-13 | H01P H03H |
| A | US 2019/221918 A1 (VOLLMER ANDREAS [DE] ET AL) 18 July 2019 (2019-07-18) * paragraph [0105] - paragraph [0115] * * figure 2 * | 1-13 | |

The present search report has been drawn up for all claims

| Place of search | Date of completion of the search | Examiner |
|---|---|---|
| The Hague | 26 April 2024 | Culhaoglu, Ali |

EPO FORM 1503 03.82 (P04C01)

**ANNEX TO THE EUROPEAN SEARCH REPORT
ON EUROPEAN PATENT APPLICATION NO.**

**EP 23 21 5178**

This annex lists the patent family members relating to the patent documents cited in the above-mentioned European search report.
The members are as contained in the European Patent Office EDP file on
The European Patent Office is in no way liable for these particulars which are merely given for the purpose of information.

**26-04-2024**

| Patent document cited in search report | Publication date | Patent family member(s) | Publication date |
|---|---|---|---|
| US 2023198114 A1 | 22-06-2023 | CN 116345100 A | 27-06-2023 |
| | | EP 4203177 A1 | 28-06-2023 |
| | | US 2023198114 A1 | 22-06-2023 |
| US 4008438 A | 15-02-1977 | DE 2547993 A1 | 20-05-1976 |
| | | JP S5149609 A | 30-04-1976 |
| | | US 4008438 A | 15-02-1977 |
| US 2019221918 A1 | 18-07-2019 | CN 109417213 A | 01-03-2019 |
| | | DE 102016007052 A1 | 07-12-2017 |
| | | EP 3449528 A1 | 06-03-2019 |
| | | JP 2019521629 A | 25-07-2019 |
| | | KR 20190015419 A | 13-02-2019 |
| | | US 2019221918 A1 | 18-07-2019 |
| | | WO 2017211451 A1 | 14-12-2017 |

EPO FORM P0459

For more details about this annex : see Official Journal of the European Patent Office, No. 12/82